(19) Europäisches Patentamt
European Patent Office
Office européen des brevets

(11) **EP 4 645 698 A1**

(12) **EUROPEAN PATENT APPLICATION**
published in accordance with Art. 153(4) EPC

(43) Date of publication:
**05.11.2025 Bulletin 2025/45**

(21) Application number: **23909624.1**

(22) Date of filing: **31.10.2023**

(51) International Patent Classification (IPC):
**H03K 17/22** (2006.01)     **G06F 1/24** (2006.01)

(52) Cooperative Patent Classification (CPC):
**G06F 1/24; H03K 17/22; Y02D 10/00**

(86) International application number:
**PCT/CN2023/128807**

(87) International publication number:
**WO 2024/139691 (04.07.2024 Gazette 2024/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **26.12.2022 CN 202211673093**

(71) Applicant: **Vanchip (Tianjin) Technology Co., Ltd.**
**Tianjin 300457 (CN)**

(72) Inventors:
• **WANG, Yongshou**
**Tianjin 300457 (CN)**
• **LIANG, Shengyu**
**Tianjin 300457 (CN)**
• **LI, Songke**
**Tianjin 300457 (CN)**

(74) Representative: **Wang, Bo**
**Panovision IP**
**Ebersberger Straße 3**
**85570 Markt Schwaben (DE)**

(54) **CHIP POWER-ON RESET MODULE, CORRESPONDING CHIP AND ELECTRONIC DEVICE**

(57) Disclosed in the present invention are a chip power-on reset module, a corresponding chip and an electronic device. The chip power-on reset module comprises a power supply state inspection circuit, a signal amplification shaping circuit, an output driving circuit and a dynamic response enhancement circuit, wherein the dynamic response enhancement circuit is used for monitoring power-on reset signals output by the output driving circuit, and locking the state of the power-on reset signals when the power-on reset signals are at a high level. The chip power-on reset module provided by the present invention can achieve a rapid positive feedback path by means of the dynamic response enhancement circuit and the output driving circuit when chips are exposed in a high-intensity electromagnetic environment, thus avoiding abnormal reset of power-on reset signals of chips, and improving stability and reliability of electronic devices.

FIG. 1

## Description

## BACKGROUND

**Technical Field**

The present disclosure relates to a chip power-on reset module, and also relates to an integrated circuit chip including the chip power-on reset module and an electronic device, belonging to the technical field of analog integrated circuits.

**Related Art**

With continuous improvement of the integration of a chip, in a mixed signal system and a chip module, the reliability of a power supply system becomes increasingly important. Because a chip power-on reset module serves as the most ubiquitous functional circuit in a chip power supply module, the operational stability thereof determines whether the entire power supply system can operate normally and stably. As the chip usually operates in a relatively complex electromagnetic operating environment, an electronic device has an extremely severe requirement on the reliability of the chip power supply module. Therefore, it is very important to design a stable and reliable chip power-on reset module to improve the reliability of the chip.

## SUMMARY

A first technical problem to be resolved by the present disclosure is to provide a chip power-on reset module. A dynamic response enhancement circuit is used in the module, and when the chip is exposed to a high-strength electromagnetic environment, it can be ensured that the chip power-on reset module is not reset abnormally.

Another technical problem to be resolved by the present disclosure is to provide an integrated circuit chip including the foregoing chip power-on reset module and a corresponding electronic device.

To achieve the above objectives, the present disclosure uses the following technical solution.

According to a first aspect of embodiments of the present disclosure, a chip power-on reset module is provided, and includes a power supply state inspection circuit, a signal amplification shaping circuit, an output driving circuit, and a dynamic response enhancement circuit, wherein

the power supply state inspection circuit is configured to detect a chip power supply, and when a power voltage state is reversed, an analog signal corresponding to a current power supply status is generated;

the signal amplification shaping circuit is configured to perform hysteretic amplification on the analog signal output by the power supply state inspection circuit, and then shape the amplified signal to output a digital signal;

the output driving circuit is configured to buffer the digital signal to drive outputting, and generate a power-on reset signal to drive a load; and

the dynamic response enhancement circuit is configured to monitor the power-on reset signal output by the output driving circuit, and lock a state of the power-on reset signal when the power-on reset signal is at a high level, where the dynamic response enhancement circuit includes a first locking circuit and a second locking circuit, the first locking circuit includes a PMOS transistor MP0 and a first capacitor C1, and the second locking circuit includes an NMOS transistor MN0 and a second capacitor C2.

Preferably, a source electrode of the PMOS transistor MP0 is connected to one end of the first capacitor C1, a drain electrode of the PMOS transistor MP0 is used as an output end of the dynamic response enhancement circuit, and a gate electrode of the PMOS transistor MP0 is connected to an output end of a first-level shaping circuit of the output driving circuit. Another end of the first capacitor C1 is connected to a power supply terminal VDD.

A drain electrode of the NMOS transistor MN0 is connected to one end of the second capacitor C2. A source electrode of the NMOS transistor MN0 is connected to a ground terminal GND, and a gate electrode of the NMOS transistor MN0 receives the power-on reset signal. Another end of the second capacitor C2 is connected to an output end of the signal amplification shaping circuit.

Preferably, the power supply state inspection circuit includes a resistor R0 and a capacitor C0 connected in series, where another end of the resistor R0 is connected to the power supply terminal VDD, and another end of the capacitor C0 is connected to the ground terminal GND.

Preferably, the power supply state inspection circuit includes a seventh PMOS transistor MP7 and the capacitor C0. A gate electrode of the seventh PMOS transistor MP7 is connected to one end of the capacitor C0 and connected to the ground terminal GND. A source electrode of the seventh PMOS transistor MP7 is connected to the power supply terminal VDD. A drain electrode of the seventh PMOS transistor MP7 is connected to another end of the capacitor C0.

Preferably, a capacitance value of the first capacitor C1 is greater than a capacitance value of the capacitor C0.

Preferably, the signal amplification shaping circuit includes a first PMOS transistor MP1, a second PMOS transistor MP2, a third PMOS transistor MP3, a fourth PMOS transistor MP4, a first NMOS transistor MN1, a second NMOS transistor MN2, a third NMOS transistor MN3, a fourth NMOS transistor MN4, a first resistor R1, and a second resistor R2. Gate electrodes of the first PMOS transistor MP1, the second PMOS transistor MP2, the first NMOS transistor MN1, and the second NMOS transistor MN2 are connected to the drain electrode of the PMOS transistor MP0. Drain electrodes of the second PMOS transistor MP2 and the second NMOS transistor MN2 are connected to one end of the second capacitor C2 and gate electrodes of the third PMOS transistor MP3 and the third NMOS transistor MN3, and serve as the output end of the signal amplification shaping circuit. The gate electrodes of the third PMOS transistor MP3 and the third NMOS transistor MN3 are connected to gate electrodes of the fourth PMOS transistor MP4 and the fourth NMOS transistor MN4. Drain electrodes of the fourth PMOS transistor MP4 and the fourth NMOS transistor MN4 are connected to each other and serve as the output end of the signal amplification shaping circuit.

Preferably, a source electrode of the first PMOS transistor MP1 is connected to the power supply terminal VDD, and a drain electrode of the first PMOS transistor MP1 is connected to source electrodes of the second PMOS transistor MP2 and the third PMOS transistor MP3. A drain electrode of the first NMOS transistor MN1 is connected to source electrodes of the second NMOS transistor MN2 and the third NMOS transistor MN3. A source electrode of the first NMOS transistor MN1 is connected to the ground terminal GND. After being connected to the first resistor R1 in series, a drain electrode of the third PMOS transistor MP3 is connected to the ground terminal GND. After being connected to the second resistor R2 in series, a drain electrode of the third NMOS transistor MN3 is connected to the power supply terminal VDD. A source electrode of the fourth PMOS transistor MP4 is connected to the power supply terminal VDD. A source electrode of the fourth NMOS transistor MN4 is connected to the ground terminal GND.

Preferably, the output driving circuit is formed by two-level shaping circuits. The first-level shaping circuit is formed by a fifth PMOS transistor MP5 and a fifth NMOS transistor MN5, and a second-level shaping circuit is formed by a sixth PMOS transistor MP6 and a sixth NMOS transistor MN6. Gate electrodes of the fifth PMOS transistor MP5 and the fifth NMOS transistor MN5 are connected to the output end of the signal amplification shaping circuit. Drain electrodes of the fifth PMOS transistor MP5 and the fifth NMOS transistor MN5 are connected to gate electrodes of the sixth PMOS transistor MP6 and the sixth NMOS transistor MN6. Source electrodes of the fifth PMOS transistor MP5 and the sixth PMOS transistor MP6 are connected to the power supply terminal VDD. Source electrodes of the fifth NMOS transistor MN5 and the sixth NMOS transistor MN6 are connected to the ground terminal GND. Drain electrodes of the sixth PMOS transistor MP6 and the sixth NMOS transistor MN6 are connected to each other, and serve as an output end of the power-on reset signal.

According to a second aspect of the embodiments of the present disclosure, an integrated circuit chip is provided, and includes the foregoing chip power-on reset module.

According to a third aspect of the embodiments of the present disclosure, an electronic device is provided, and includes the foregoing chip power-on reset module.

Compared with the prior art, the chip power-on reset module provided in the embodiments of the present disclosure can implement a fast positive feedback path by the dynamic response enhancement circuit and the output driving circuit when the chip is exposed to a high-strength electromagnetic environment, to ensure that the power-on reset signal of the chip is not reset abnormally, thereby improving stability and reliability of the electronic device. In addition, introducing the chip power-on reset module does not increase sensitivity of the power-on reset signal to rising and falling rates of a power voltage, and also does not increase any static power consumption.

## BRIEF DESCRIPTION OF THE DRAWINGS

FIG. 1 is a schematic diagram of an architecture of a chip power-on reset module provided by an embodiment of the present disclosure;

FIG. 2 is a specific circuit diagram of a chip power-on reset module in a first embodiment of the present disclosure;

FIG. 3 is a specific circuit diagram of a chip power-on reset module in a second embodiment of the present disclosure;

FIG. 4 is a diagram of an anti-interference effect of a chip power-on reset module provided by an embodiment of the present disclosure; and

FIG. 5 is a schematic diagram of a system of an electronic device provided by an embodiment of the present disclosure.

**DETAILED DESCRIPTION**

The technical content of the present disclosure is described in detail below with reference to the drawings and embodiments.

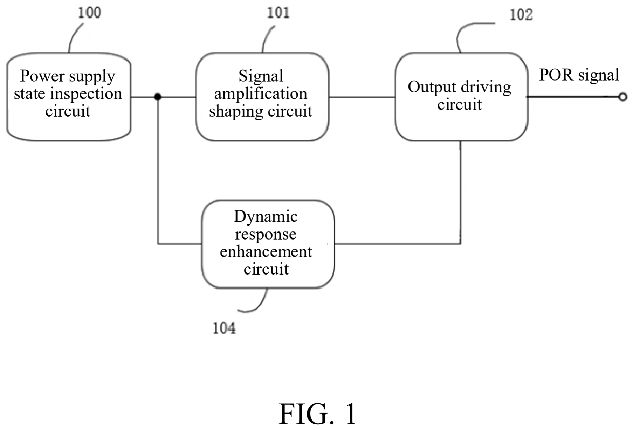

As shown in FIG. 1, an embodiment of the present disclosure first provides a chip power-on reset module, which at least includes a power supply state inspection circuit 100, a signal amplification shaping circuit 101, an output driving circuit 102, and a dynamic response enhancement circuit 104. The power supply state inspection circuit 100 is configured to detect a chip power supply, and when a voltage state of a power supply terminal VDD is reversed, the power supply state inspection circuit 100 generates an analog signal corresponding to a current power supply status. The signal amplification shaping circuit 101 is configured to process the analog signal output by the power supply state inspection circuit 100. The signal amplification shaping circuit 101 performs hysteretic amplification on the analog signal output by the power supply state inspection circuit 100, and shapes the amplified signal into a digital signal for external output. The output driving circuit 102 is configured to drive outputting of the digital signal output by the signal amplification shaping circuit 101, and an output thereof is used as a power-on reset (POR) signal. The dynamic response enhancement circuit 104 is configured to monitor a state of the POR signal output by the output driving circuit 102 to form a positive feedback path. When the POR signal is at a high level, a state of the POR signal is locked, so that the POR signal can be stabilized in an original operating state when voltages of a power port and a ground port of an electronic device jump, thereby avoiding an erroneous reset situation.

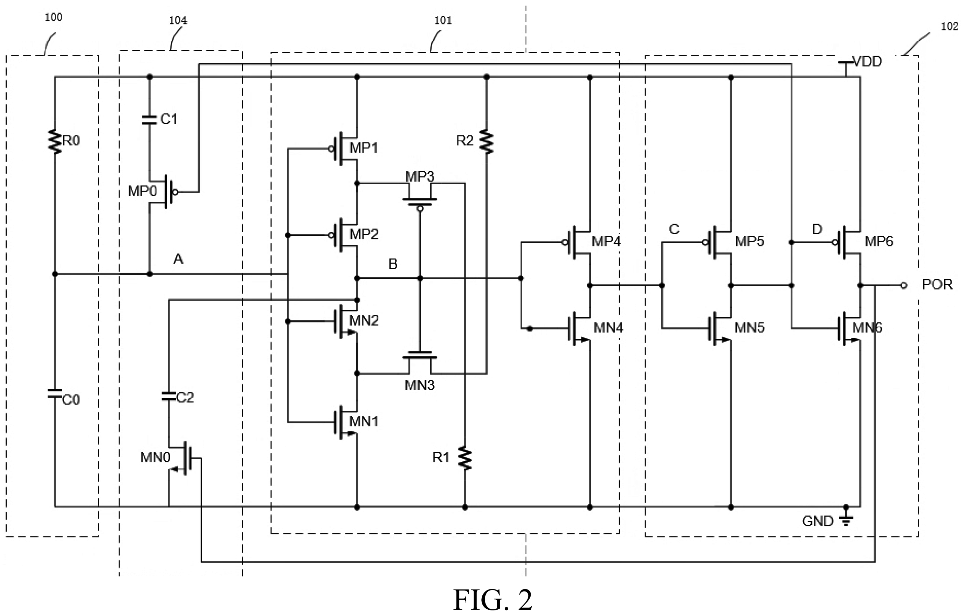

As shown in FIG. 2, in a first embodiment of the present disclosure, the power supply state inspection circuit 100 includes a resistor R0 and a capacitor C0 connected in series to form a low-pass filter circuit. Another end of the resistor R0 is connected to the power supply terminal VDD. Another end of the capacitor C0 is connected to a ground terminal GND. A connection point between the resistor R0 and the capacitor C0 is marked as a point A. A voltage signal of the point is used as an input signal and respectively input to the signal amplification shaping circuit 101 and the dynamic response enhancement circuit 104.

In an embodiment of the present disclosure, the signal amplification shaping circuit 101 includes a first PMOS transistor MP1, a second PMOS transistor MP2, a third PMOS transistor MP3, a fourth PMOS transistor MP4, a first NMOS transistor MN1, a second NMOS transistor MN2, a third NMOS transistor MN3, a fourth NMOS transistor MN4, a first resistor R1, and a second resistor R2. Gate electrodes of the first PMOS transistor MP1, the second PMOS transistor MP2, the first NMOS transistor MN1, and the second NMOS transistor MN2 are connected to a drain electrode of a PMOS transistor MP0. Drain electrodes of the second PMOS transistor MP2 and the second NMOS transistor MN2 are connected to one end of the second capacitor C2 and gate electrodes of the third PMOS transistor MP3 and the third NMOS transistor MN3, and serve as an amplified signal output end (output end for short) of the signal amplification shaping circuit 101. The gate electrodes of the third PMOS transistor MP3 and the third NMOS transistor MN3 are connected to gate electrodes of the fourth PMOS transistor MP4 and the fourth NMOS transistor MN4. Drain electrodes of the fourth PMOS transistor MP4 and the fourth NMOS transistor MN4 are connected to each other and serve as the output end of the signal amplification shaping circuit 101. The output end of the signal amplification shaping circuit 101 is connected to an input end of the output driving circuit 102.

In the signal amplification shaping circuit 101, a source electrode of the first PMOS transistor MP1 is connected to the power supply terminal VDD, and a drain electrode of the first PMOS transistor MP1 is connected to source electrodes of the second PMOS transistor MP2 and the third PMOS transistor MP3. A drain electrode of the first NMOS transistor MN1 is connected to source electrodes of the second NMOS transistor MN2 and the third NMOS transistor MN3. A source electrode of the first NMOS transistor MN1 is connected to the ground terminal GND. After being connected to the first resistor R1 in series, a drain electrode of the third PMOS transistor MP3 is connected to the ground terminal GND. After being connected to the second resistor R2 in series, a drain electrode of the third NMOS transistor MN3 is connected to the power supply terminal VDD. A source electrode of the fourth PMOS transistor MP4 is connected to the power supply terminal VDD. A source electrode of the fourth NMOS transistor MN4 is connected to the ground terminal GND.

A hysteresis amplifier formed by the first PMOS transistor MP1, the second PMOS transistor MP2, the third PMOS transistor MP3, the first NMOS transistor MN1, the second NMOS transistor MN2, the third NMOS transistor MN3, the first resistor R1, and the second resistor R2 performs hysteretic amplification on a voltage of the point A (that is, the connection point between the resistor R0 and the capacitor C0 in the power supply state inspection circuit 100). The fourth PMOS transistor MP4 and the fourth NMOS transistor MN4 are connected in an inverter manner to form a shaping circuit, which shapes an output voltage of the hysteresis amplifier to output a full-swing signal (that is, a signal of a node C). It should be noted that the foregoing shaping circuit may be replaced with a Schmitt inverter or an inverter in another type.

The output driving circuit 102 is configured to buffer an output signal (that is, the signal of the node C) of the signal amplification shaping circuit 101 to drive outputting thereof, and generate the POR signal so as to drive a relatively large load. In an embodiment of the present disclosure, the output driving circuit 102 is formed by two-level shaping circuits. A first-level shaping circuit is formed by a fifth PMOS transistor MP5 and a fifth NMOS transistor MN5, and a second-level shaping circuit is formed by a sixth PMOS transistor MP6 and a sixth NMOS transistor MN6. Gate electrodes of the fifth PMOS transistor MP5 and the fifth NMOS transistor MN5 are connected to the output end of the signal amplification shaping circuit 101. Drain electrodes of the fifth PMOS transistor MP5 and the fifth NMOS transistor MN5 are connected to gate electrodes of the sixth PMOS transistor MP6 and the sixth NMOS transistor MN6. Source electrodes of the fifth PMOS transistor MP5 and the sixth PMOS transistor MP6 are connected to the power supply terminal VDD. Source electrodes of the fifth NMOS transistor MN5 and the sixth NMOS transistor MN6 are connected to the ground terminal GND. Drain electrodes of the sixth PMOS transistor MP6 and the sixth NMOS transistor MN6 are connected to each other, and serve as an output end of the POR signal.

In an embodiment of the present disclosure, the dynamic response enhancement circuit 104 includes a first locking circuit and a second locking circuit. The first locking circuit includes the PMOS transistor MP0 and a first capacitor C1, and the second locking circuit includes an NMOS transistor MN0 and a second capacitor C2. In the dynamic response enhancement circuit 104, a source electrode of the PMOS transistor MP0 is connected to one end of the first capacitor C1, the drain electrode of the PMOS transistor MP0 is used as an output end of the dynamic response enhancement circuit 104, and a gate electrode of the PMOS transistor MP0 is connected to an output end of the first-level shaping circuit of the output driving circuit 102. Another end of the first capacitor C1 is connected to the power supply terminal VDD. A drain electrode of the NMOS transistor MN0 is connected to one end of the second capacitor C2. A source electrode of the NMOS transistor MN0 is connected to the ground terminal GND, and a gate electrode of the NMOS transistor MN0 is connected to the POR signal. Another end of the second capacitor C2 is connected to the output end of the signal amplification shaping circuit 101.

In an embodiment of the present disclosure, when a voltage of the power supply terminal VDD gradually increases from zero, it indicates that the chip is in a power-on state. When the chip starts to power on, the voltage of the power supply terminal VDD gradually increases. The capacitor C0 in the power supply state inspection circuit 100 is in a charging state. A potential of the point A (that is, the connection point between the resistor R0 and the capacitor C0) exhibits hysteresis relative to the voltage of the power supply terminal VDD. Therefore, the potential of the point A cannot be immediately greater than a reversion voltage of the hysteresis amplifier in the signal amplification shaping circuit 101 (namely, $V_A <$Vhsys). In this case, a circuit state is specifically as follows: a voltage of the point A is lower than the reversion voltage Vhsys of the signal amplification shaping circuit 101, a voltage of a point B is the voltage of the power supply terminal VDD, a voltage of a point C is 0, a voltage of a point D is VDD, and the POR signal is at a low level. In this case, the PMOS transistor MP0 and the NMOS transistor MN0 in the dynamic response enhancement circuit 104 are both turned off, and the first capacitor C1 and the second capacitor C2 are in a high-resistance state circuit.

When the voltage of the power supply terminal VDD gradually increases to a certain degree, after the voltage of the point A is greater than the reversion voltage of the hysteresis amplifier in the signal amplification shaping circuit 101 (namely, $V_A \geq$Vhsys), the voltage of the point B is reversed to 0, the voltage of the point C is reversed to VDD, the voltage of the point D is reversed to 0, the POR signal is reversed to VDD, and after that, the POR signal continues to increase with the voltage of the power supply terminal VDD (namely, $V_{POR}=$VDD) . In this case, states of the components in the dynamic response enhancement circuit 104 are as follows: The $\overline{PMOS}$ transistor MP0 and the NMOS transistor MN0 are turned on, the first capacitor C1 is connected to a node A through the PMOS transistor MP0, and the second capacitor C2 is connected to the ground terminal GND through the NMOS transistor MN0. In a process in which the voltage of the power supply terminal VDD increases, a voltage of an electrode plate of the first capacitor C1 connected to the power supply terminal VDD always increases with the voltage of the power supply terminal VDD. When a state of the POR signal is reversed, the PMOS transistor MP0 is turned on, and the voltage of the point A is rapidly charged to the voltage of the power supply terminal VDD, thereby ensuring stability of the voltage at the point A. At the same time, a voltage of an electrode plate of the second capacitor C2 connected to the NMOS transistor MN0 is rapidly discharged to 0, and the voltage of the point B accelerates discharging to a steady state. Therefore, after the state of the POR signal reaches a reversion condition, the dynamic response enhancement circuit 104 may quickly lock the state of the POR signal, thereby helping the chip power-on reset module to quickly reach a steady state.

After the chip power-on reset module reaches the steady state, if the voltage of the power supply terminal VDD or the ground terminal GND greatly jumps due to some high-frequency electromagnetic interference, the dynamic response enhancement circuit 104 can play a role of increasing a feedback depth and hysteresis, so that the POR signal can closely follow a change of the voltage of the power supply terminal VDD, thereby avoiding an erroneous POR situation. Specific descriptions are as follows:

A principle that the dynamic response enhancement circuit 104 can suppress erroneous reset of the POR signal caused by a high-frequency large-amplitude change of the voltage of the power supply terminal VDD or the ground terminal GND is as follows: After the chip is powered on completely, the output POR signal is at a high level, that is, the voltage of the power supply terminal VDD. In this case, a gate voltage of the PMOS transistor MP0 and a gate voltage of the NMOS transistor MN0 are the voltage of the ground terminal GND and the voltage of the power supply terminal VDD, respectively.

If a high-frequency large-swing interference signal $\Delta V$ occurs on the voltage of the power supply terminal VDD, a dynamic voltage Vdd of the power supply terminal is obtained according to the following formula (1):

$$V_{dd} = V_{DD} \pm \Delta V \qquad (1)$$

Due to the function of the first capacitor C1, at this time, the voltage $V_A$ of the point A is determined by a partial voltage of the first capacitor C1 and the capacitor C0, and $V_A$ is obtained according to the following formula (2):

$$V_A = V_{dd} \left( \frac{C_1}{C_0 + C_1} \right) \qquad (2)$$

Therefore, a proper capacitance value is selected for the first capacitor C1, so that the first capacitor C1 > the capacitor C0, and the voltage of the point A favorably changes with Vdd. If the first capacitor C1 >> the capacitor C0 (that is, a capacitance value of the first capacitor C1 is much greater than a capacitance value of the capacitor C0, for example, 10 times or higher), $V_A$ (the voltage of the point A)≈Vdd. Thus it can be seen that when the dynamic voltage Vdd of the power supply terminal encounters a strong interference signal, an input signal of the signal amplification shaping circuit 101 can change with the dynamic voltage Vdd, so that the signal amplification shaping circuit 101 does not have state reversion in the process. At the same time, due to the presence of the grounded second capacitor C2 at the point B, and the fact that the signal amplification shaping circuit 101 does not detect a change of a signal at the input end, a current is output to charge the second capacitor C2 at the point B, that is, $V_B$=0. Therefore, an output of the signal amplification shaping circuit 101 does not significantly change in a process in which the voltage Vdd of the power supply terminal jumps, so that the POR signal output by the output driving circuit 102 can change closely following the jump of the voltage Vdd of the power supply terminal, thereby avoiding generation of an erroneous reset signal.

On the other hand, if a high-frequency large-swing interference signal $\Delta V$ occurs only on the GND port, the voltage $V_{gnd}$ of the ground terminal GND is obtained according to the following formula (3):

$$V_{gnd} = V_{GND} \pm \Delta V \qquad (3)$$

The voltage $V_A$ of the point A is also determined by the capacitor C0 and the first capacitor C1. Specifically, the voltage $V_A$ is obtained according to the following formula (4):

$$V_A = V_{gnd} \left( \frac{C_0}{C_0 + C_1} \right) \qquad (4)$$

When a relatively large capacitance value is selected for the first capacitor C1 relative to the capacitor C0, the voltage of the point A may be controlled to a very low level. That is, when the first capacitor C1 >> the capacitor C0, the voltage $V_A$ hardly changes with a change of the voltage of the ground terminal GND. In addition, due to the presence of the second capacitor C2, the voltage of the point B can change with the change of the voltage of the ground terminal GND. Therefore, the output signal of the signal amplification shaping circuit 101 does not have state reversion when the voltage of the ground terminal GND jumps, so that the output POR signal does not have erroneous reversion caused by the jump of the voltage of the ground terminal GND.

Thus it can be seen from the foregoing that an essential function of the dynamic response enhancement circuit 104 is to generate a positive feedback fast path, to ensure that states of the node A and a node B do not greatly change with fluctuations of the voltages of the power supply terminal VDD and the ground terminal GND, thereby avoiding a problem that the output POR signal has erroneous reversion caused by instantaneous fluctuations of the voltages of the power supply terminal VDD and the ground terminal GND.

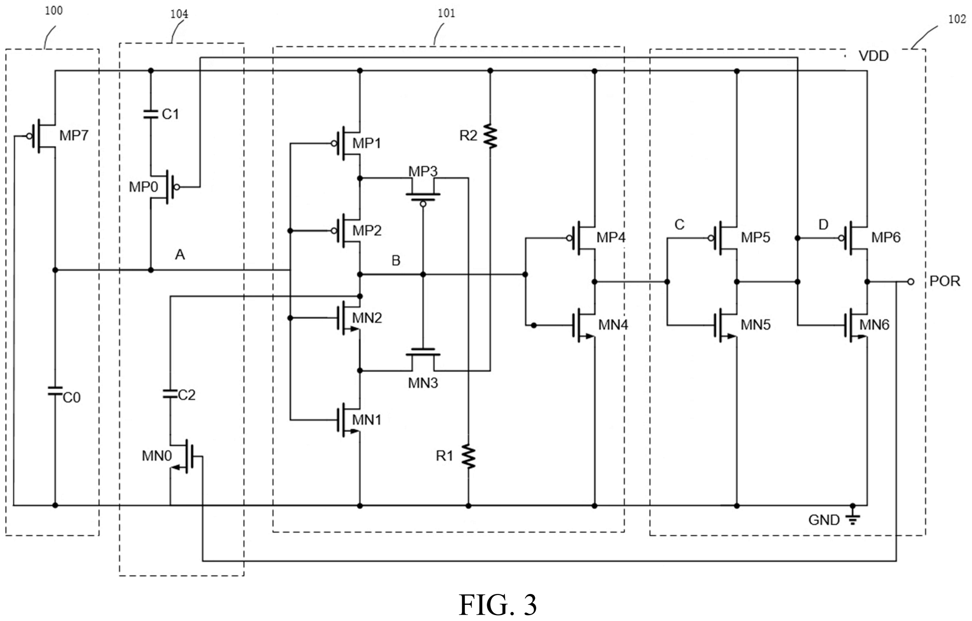

FIG. 3 shows another embodiment of the chip power-on reset module provided by the present disclosure. In this embodiment, a basic architecture of the chip power-on reset module is basically the same as that of the first embodiment shown in FIG. 2, and no further details are provided herein again. The main difference between the two lies in that: in a second embodiment shown in FIG. 3, the power supply state inspection circuit 100 includes a seventh PMOS transistor MP7 and the capacitor C0. A gate electrode of the seventh PMOS transistor MP7 is connected to one end of the capacitor C0 and connected to the ground terminal GND. A source electrode of the seventh PMOS transistor MP7 is connected to the power supply terminal VDD. A drain electrode of the seventh PMOS transistor MP7 is connected to the other end of the capacitor C0. A circuit of a remaining part of the second embodiment is basically the same as that of the first embodiment shown in FIG. 2, and no further details are provided herein again.

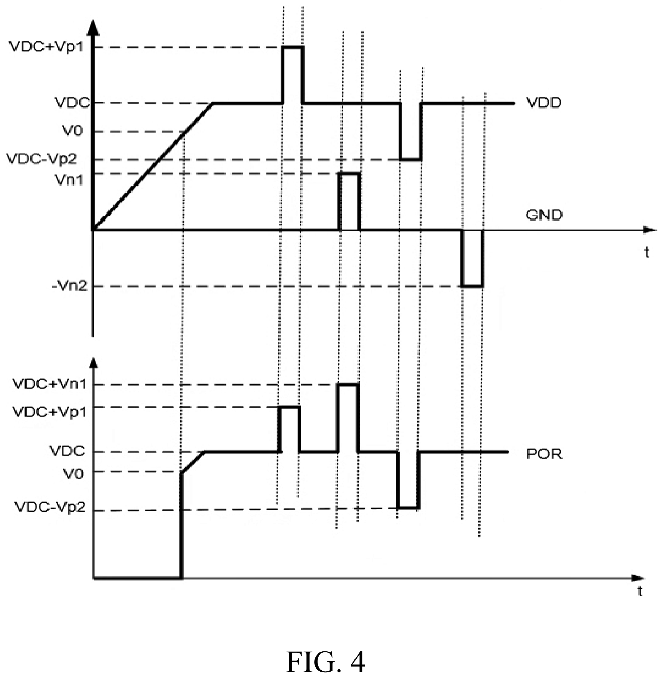

FIG. 4 shows an anti-interference effect of the chip power-on reset module provided by the embodiment of the present disclosure. A case in which the voltages of the power supply terminal VDD and the ground terminal GND change with time and interference and a case in which the POR signal changes correspondingly are provided sequentially from top to bottom. Thus it can be seen that when the POR signal is at a high level, a state of the POR signal can be locked, so that the POR signal can be stabilized in an original operating state when the voltages of the power supply terminal (VDD) and the ground terminal (GND) of the electronic device jump, thereby avoiding an erroneous reset situation.

In addition, the chip power-on reset module provided in the embodiment of the present disclosure may be used in an integrated circuit chip. Specific structures of the chip power-on reset module in the integrated circuit chip will not be described in detail herein.

The foregoing chip power-on reset module may further be used in an electronic device, as an important component of a power supply assembly. The electronic device herein refers to a device that can be used in a mobile environment and supports various communication standards such as GSM, EDGE, TD_SCDMA, TDD_LTE, and FDD_LTE, and includes a mobile phone, a notebook computer, a tablet computer, an Internet of vehicles terminal, and the like. In addition, the technical solutions provided in the present disclosure are also applicable to an application scenario of other power supply assemblies, such as a communication base station and an intelligent connected vehicle.

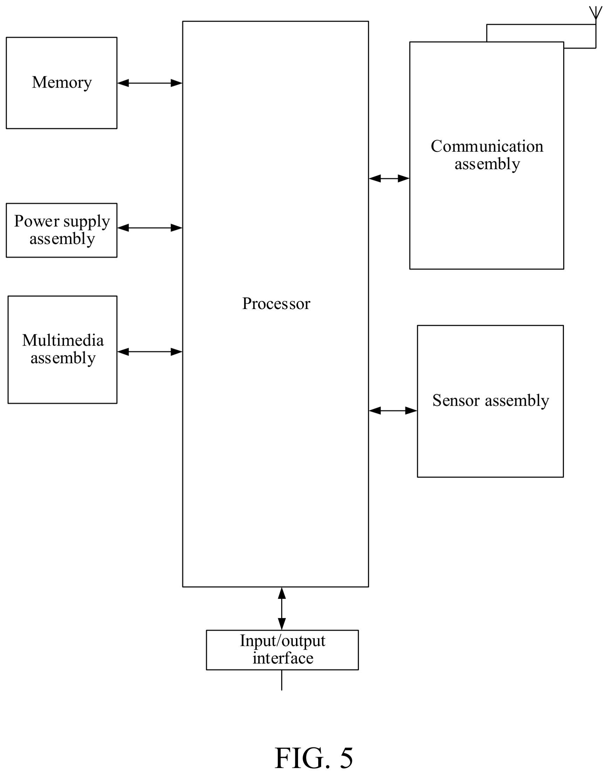

As shown in FIG. 5, the electronic device at least includes a processor and a memory, and may further include a communication assembly, a sensor assembly, a power supply assembly, a multimedia assembly, and an input/output interface according to actual requirements. The memory, the communication assembly, the sensor assembly, the power supply assembly, the multimedia assembly, and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field programmable gate array (FPGA), an application-specific integrated circuit (ASIC), a digital signal processing (DSP) chip, or the like. Other communication assemblies, sensor assemblies, power supply assemblies, multimedia assemblies, and the like may all be implemented by using common components, which are not specifically described herein.

Compared with the prior art, the chip power-on reset module provided in the embodiments of the present disclosure can implement a fast positive feedback path by the dynamic response enhancement circuit and the output driving circuit when the chip is exposed to a high-strength electromagnetic environment, to ensure that the POR signal of the chip is not reset abnormally, thereby improving stability and reliability of the electronic device. In addition, introducing the chip power-on reset module does not increase sensitivity of the POR signal to rising and falling rates of a power voltage, and also does not increase any static power consumption.

The foregoing describes the chip power-on reset module, the chip, and the electronic device provided in the present disclosure in detail. Any obvious change made by a person of ordinary skill in the art to the present disclosure without departing from the essential content of the present disclosure shall constitute a violation of the patent right of the present disclosure and shall take corresponding legal responsibility.

**Claims**

1. A chip power-on reset module, comprising a power supply state inspection circuit, a signal amplification shaping circuit, an output driving circuit, and a dynamic response enhancement circuit, wherein

   the power supply state inspection circuit is configured to detect a chip power supply, and when a power voltage state is reversed, an analog signal corresponding to a current power supply status is generated;
   the signal amplification shaping circuit is configured to perform hysteretic amplification on the analog signal output by the power supply state inspection circuit, and then shape the amplified signal to output a digital signal;
   the output driving circuit is configured to buffer the digital signal to drive outputting, and generate a power-on reset signal to drive a load; and
   the dynamic response enhancement circuit is configured to monitor the power-on reset signal output by the output driving circuit, and lock a state of the power-on reset signal when the power-on reset signal is at a high level, wherein the dynamic response enhancement circuit comprises a first locking circuit and a second locking circuit, the first locking circuit comprises a PMOS transistor (MP0) and a first capacitor (C1), and the second locking circuit comprises an NMOS transistor (MN0) and a second capacitor (C2).

2. The chip power-on reset module according to claim 1, wherein

   a source electrode of the PMOS transistor (MP0) is connected to one end of the first capacitor (C1), a drain electrode of the PMOS transistor (MP0) is used as an output end of the dynamic response enhancement circuit, and a gate electrode of the PMOS transistor (MP0) is connected to an output end of a first-level shaping circuit of the output driving circuit; and another end of the first capacitor (C1) is connected to a power supply terminal (VDD); and
   a drain electrode of the NMOS transistor (MN0) is connected to one end of the second capacitor (C2); a source electrode of the NMOS transistor (MN0) is connected to a ground terminal (GND), and a gate electrode of the NMOS transistor (MN0) receives the power-on reset signal; and another end of the second capacitor (C2) is connected to an output end of the signal amplification shaping circuit.

3.   The chip power-on reset module according to claim 2, wherein
the power supply state inspection circuit comprises a resistor (R0) and a capacitor (C0) connected in series, wherein another end of the resistor (R0) is connected to the power supply terminal (VDD), and another end of the capacitor (C0) is connected to the ground terminal (GND).

4.   The chip power-on reset module according to claim 2, wherein
the power supply state inspection circuit comprises a seventh PMOS transistor (MP7) and a capacitor (C0); a gate electrode of the seventh PMOS transistor (MP7) is connected to one end of the capacitor (C0) and connected to the ground terminal (GND); a source electrode of the seventh PMOS transistor (MP7) is connected to the power supply terminal (VDD); and a drain electrode of the seventh PMOS transistor (MP7) is connected to another end of the capacitor (C0).

5.   The chip power-on reset module according to claim 3 or 4, wherein
a capacitance value of the first capacitor (C1) is greater than a capacitance value of the capacitor (C0).

6.   The chip power-on reset module according to claim 1, wherein
the signal amplification shaping circuit comprises a first PMOS transistor (MP1), a second PMOS transistor (MP2), a third PMOS transistor (MP3), a fourth PMOS transistor (MP4), a first NMOS transistor (MN1), a second NMOS transistor (MN2), a third NMOS transistor (MN3), a fourth NMOS transistor (MN4), a first resistor (R1), and a second resistor (R2), wherein gate electrodes of the first PMOS transistor (MP1), the second PMOS transistor (MP2), the first NMOS transistor (MN1), and the second NMOS transistor (MN2) are connected to a drain electrode of the PMOS transistor (MP0); drain electrodes of the second PMOS transistor (MP2) and the second NMOS transistor (MN2) are connected to one end of the second capacitor (C2) and gate electrodes of the third PMOS transistor (MP3) and the third NMOS transistor (MN3), and serve as an output end of the signal amplification shaping circuit; the gate electrodes of the third PMOS transistor (MP3) and the third NMOS transistor (MN3) are connected to gate electrodes of the fourth PMOS transistor (MP4) and the fourth NMOS transistor (MN4); and drain electrodes of the fourth PMOS transistor (MP4) and the fourth NMOS transistor (MN4) are connected to each other and serve as the output end of the signal amplification shaping circuit.

7.   The chip power-on reset module according to claim 6, wherein
a source electrode of the first PMOS transistor (MP1) is connected to a power supply terminal (VDD), and a drain electrode of the first PMOS transistor (MP1) is connected to source electrodes of the second PMOS transistor (MP2) and the third PMOS transistor (MP3); a drain electrode of the first NMOS transistor (MN1) is connected to source electrodes of the second NMOS transistor (MN2) and the third NMOS transistor (MN3); a source electrode of the first NMOS transistor (MN1) is connected to a ground terminal (GND); after being connected to the first resistor (R1) in series, a drain electrode of the third PMOS transistor (MP3) is connected to the ground terminal (GND); after being connected to the second resistor (R2) in series, a drain electrode of the third NMOS transistor (MN3) is connected to the power supply terminal (VDD); a source electrode of the fourth PMOS transistor (MP4) is connected to the power supply terminal (VDD); and a source electrode of the fourth NMOS transistor (MN4) is connected to the ground terminal (GND).

8.   The chip power-on reset module according to claim 1, wherein
the output driving circuit is formed by two-level shaping circuits, wherein a first-level shaping circuit is formed by a fifth PMOS transistor (MP5) and a fifth NMOS transistor (MN5), and a second-level shaping circuit is formed by a sixth PMOS transistor (MP6) and a sixth NMOS transistor (MN6); gate electrodes of the fifth PMOS transistor (MP5) and the fifth NMOS transistor (MN5) are connected to an output end of the signal amplification shaping circuit; drain electrodes of the fifth PMOS transistor (MP5) and the fifth NMOS transistor (MN5) are connected to gate electrodes of the sixth PMOS transistor (MP6) and the sixth NMOS transistor (MN6); source electrodes of the fifth PMOS transistor (MP5) and the sixth PMOS transistor (MP6) are connected to a power supply terminal (VDD); the source electrodes of the fifth NMOS transistor (MN5) and the sixth NMOS transistor (MN6) are connected to a ground terminal (GND); and drain electrodes of the sixth PMOS transistor (MP6) and the sixth NMOS transistor (MN6) are connected to each other, and serve as an output end of the power-on reset signal.

9.   An integrated circuit chip, comprising the chip power-on reset module according to any one of claims 1 to 8.

**10.** An electronic device, comprising the chip power-on reset module according to any one of claims 1 to 8.

FIG. 1

FIG. 2

EP 4 645 698 A1

FIG. 3

FIG. 4

Memory

Power supply
assembly

Multimedia
assembly

Processor

Communication
assembly

Sensor assembly

Input/output
interface

# FIG. 5

## INTERNATIONAL SEARCH REPORT

| International application No. |
| --- |
| **PCT/CN2023/128807** |

| A. | CLASSIFICATION OF SUBJECT MATTER |
| --- | --- |

H03K17/22(2006.01)i;  G06F1/24(2006.01)i

According to International Patent Classification (IPC) or to both national classification and IPC

| B. | FIELDS SEARCHED |
| --- | --- |

Minimum documentation searched (classification system followed by classification symbols)

    IPC:  H03K;  G06F

Documentation searched other than minimum documentation to the extent that such documents are included in the fields searched

Electronic data base consulted during the international search (name of data base and, where practicable, search terms used)

    VEN, CNABS, CNTXT, WOTXT, EPTXT, USTXT, CNKI, IEEE: 芯片, 上电复位, 放大, 整形, 迟滞, 延迟, 缓冲, 动态, 响应, 反馈, 锁定, 锁存, 高电平, 翻转, 跳变, 电容, 电阻, 电源, 源极, 漏极, 接地, 栅极, 反相, chip, POR, power on reset, amplif+, shap+, delay, response, feedback, lock, latch, high flip, jump, capacitance, resistance, source, drain, gate, invert, PMOS, NMOS

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 115987259 A (VANCHIP (TIANJIN) ELECTRONIC TECHNOLOGY CO., LTD.) 18 April 2023 (2023-04-18)<br>    claims 1-10 | 1-10 |
| X | CN 102111136 A (HI-TREND TECHNOLOGY (SHANGHAI) CO., LTD.) 29 June 2011 (2011-06-29)<br>    description, paragraphs [0032]-[0065], and figure 4 | 1-10 |
| X | CN 102403988 A (SHANGHAI INSTITUTE OF MICROSYSTEM AND INFORMATION TECHNOLOGY, CHINESE ACADEMY OF SCIENCES) 04 April 2012 (2012-04-04)<br>    description, paragraphs [0032]-[0047], and figures 2 and 3 | 1-10 |
| A | CN 104682931 A (BEIHAI YUNXIN ELECTRONIC TECHNOLOGY CO., LTD.) 03 June 2015 (2015-06-03)<br>    entire document | 1-10 |
| A | CN 113821068 A (SICHUAN CHUANG'AN MICROELECTRONICS CO., LTD.) 21 December 2021 (2021-12-21)<br>    entire document | 1-10 |

☑ Further documents are listed in the continuation of Box C.      ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **30 January 2024** | **02 February 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2023/128807** |

**C.    DOCUMENTS CONSIDERED TO BE RELEVANT**

| Category* | Citation of document, with indication, where appropriate, of the relevant passages | Relevant to claim No. |
|---|---|---|
| A | CN 203166853 U (XIANGTAN UNIVERSITY) 28 August 2013 (2013-08-28)<br>entire document | 1-10 |
| A | KR 20030052365 A (HYNIX SEMICONDUCTOR INC.) 27 June 2003 (2003-06-27)<br>entire document | 1-10 |
| A | US 10348292 B1 (WINBOND ELECTRONICS CORP.) 09 July 2019 (2019-07-09)<br>entire document | 1-10 |

Form PCT/ISA/210 (second sheet) (July 2022)

## INTERNATIONAL SEARCH REPORT
### Information on patent family members

International application No.

**PCT/CN2023/128807**

| Patent document cited in search report | | | Publication date (day/month/year) | Patent family member(s) | Publication date (day/month/year) |
|---|---|---|---|---|---|
| CN | 115987259 | A | 18 April 2023 | None | |
| CN | 102111136 | A | 29 June 2011 | None | |
| CN | 102403988 | A | 04 April 2012 | None | |
| CN | 104682931 | A | 03 June 2015 | None | |
| CN | 113821068 | A | 21 December 2021 | None | |
| CN | 203166853 | U | 28 August 2013 | None | |
| KR | 20030052365 | A | 27 June 2003 | None | |
| US | 10348292 | B1 | 09 July 2019 | None | |

Form PCT/ISA/210 (patent family annex) (July 2022)